(19) Europäisches Patentamt
European Patent Office
Office européen des brevets

(11) EP 2 444 991 A1

(12) EUROPEAN PATENT APPLICATION

(43) Date of publication:
25.04.2012 Bulletin 2012/17

(51) Int Cl.:
*H01J 37/22* (2006.01)   *H01J 37/28* (2006.01)

(21) Application number: 10188162.1

(22) Date of filing: 20.10.2010

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: FEI Company
Hillsboro, OR 97124-5793 (US)

(72) Inventors:
• Boughorbel, Faysal
5623 LD Eindhoven (NL)

• Lich, Berend
6002 AR Weert (NL)
• Bosch, Eric
5629 HB Eindhoven (NL)
• Kooijman, Cornelis
5501 BC Veldhoven (NL)

(74) Representative: Bakker, Hendrik
FEI Company
Patent Department
P.O. Box 1745
5602 BS  Eindhoven (NL)

(54) **SEM imaging method**

(57)    A method of investigating a sample using Scanning Electron Microscopy (SEM), comprising the following steps:
- Irradiating a surface (S) of the sample using a probing electron beam in a plurality (N) of measurement sessions, each measurement session having an associated beam parameter (P) value that is chosen from a range of such values and that differs between measurement sessions;
- Detecting stimulated radiation emitted by the sample during each measurement session, associating a measurand (M) therewith and noting the value of this measurand for each measurement session, thus allowing compilation of a data set (D) of data pairs $(P_i, M_i)$, where $1 \leq i \leq N$,

wherein:
- A statistical Blind Source Separation (BSS) technique is employed to automatically process the data set (D) and spatially resolve it into a result set (R) of imaging pairs $(Q_k, L_k)$, in which an imaging quantity (Q) having value $Q_k$ is associated with a discrete depth level $L_k$ referenced to the surface S.

A suitable example of such a BSS technique is Principal Component Analysis (PCA), e.g. employing a Karhunen-Loeve transform operation.
This technique allows high-resolution 3D volume reconstruction from a sequence of backscattered images acquired by a SEM. The method differs from known techniques in that it can be used on complex samples with unknown structure. With this method, one can compute compensation factors between high- and low-energy images using second-order (or higher-order) multivariate statistics, which allows for the effective separation of different depth layers in a sample without using a *priori* knowledge of sample structure. The method has a wide range of applications in life-science and material science imaging.

Fig. 1

EP 2 444 991 A1

**Description**

The invention relates to a method of investigating a sample using Scanning Electron Microscopy (SEM), comprising the following steps:

- Irradiating a surface (S) of the sample using a probing electron beam in a plurality (N) of measurement sessions, each measurement session having an associated beam parameter (P) value that is chosen from a range of such values and that differs between measurement sessions;
- Detecting stimulated radiation emitted by the sample during each measurement session, associating a measurand (M) therewith and noting the value of this measurand for each measurement session, thus allowing compilation of a data set (D) of data pairs $(P_i, M_i)$, where $1 \leq i \leq N$.

A method as set forth in the opening paragraph is known from United States Patent US 5,412,210, and makes use of the insight that changing the primary beam energy in SEM leads to deeper penetration inside the sample being investigated. In principle, such an approach can be used to generate three-dimensional (3D) tomograms of regions of interest in the sample. Up to now, attempts to exploit this approach have involved acquiring two or more images with increasing primary beam energy, adjusting contrast between the images, and then subtracting lower-energy images from higher-energy images to reveal submerged layers in the sample.

A drawback of such known approaches is that said inter-image contrast adjustment (which is a key step) can only be performed using knowledge about the composition and geometry of the sample. Consequently, prior applications of this technique have tended to limit themselves to wafer defect inspection and other semiconductor applications, in which there is generally good a *priori* knowledge of the sample's (default) composition and geometry. Since the required compositional and geometrical information is typically not available for biological samples, the known technique has not yet been successfully applied to investigations in the life sciences.

It is an object of the present invention to address the issue set forth above. More specifically, it is an object of the present invention to provide a SEM imaging method that lends itself to application with samples comprising unknown composition/geometry. In particular, it is an object of the present invention that such a method should allow automatic de-convolution of measured SEM data, and automatic generation of depth- resolved imagery.

These and other objects are obtained in a SEM-based method as set forth in the opening paragraph, characterized in that a statistical Blind Source Separation technique is employed to automatically process the data set (D) and spatially resolve it into a result set (R) of imaging pairs $(Q_k, L_k)$, in which an imaging quantity (Q) having value $Q_k$ is associated with a discrete depth level $L_k$ referenced to the surface S.

In research leading to the invention, the inventors realized that, for complex samples with unknown structures (such as those encountered in biological applications, for example), it is generally not possible to perform the prior-art signal value adjustment through user input. This is due *inter alia* to the fact that characteristics at a scanned location (such as the density and thickness of stain for biological samples) are not known *a priori* to the SEM user. Given that the SEM image is formed as a localized interaction between the employed (scanned) electron beam and irradiated sample areas having such unknown characteristics, having no more information at hand than the employed beam properties will prevent determination of signal adjustment factors. Moreover, the content of deeper layers (levels) will be unknown, thus preventing the user from reliably using multiple trials at different adjustment parameters in order to reveal some information about subsurface regions.

To deal with this problem, the inventors set themselves the goal of developing an *automatic* approach for determining scaling factors from measured data. In analyses that ultimately culminated in the development of the present inventive approach, the inventors arrived at the following insights:

- Signals associated with backscattered (BS) electrons generally yield sufficient information from all generation depths within their detectable range.
- The mathematical Point Spread Function (PSF) of BS electrons in several types of samples, including stained bio-samples and polymers, is generally (highly) linear.
- The PSF of detectable BS electrons in such samples was also shown to be (highly) laterally confined throughout a depth of several tens of nanometers (more than 50 nm). This fact proves to be highly useful for 3D volume imaging, since it means that one will have a relatively low loss of lateral resolution if one uses BS signals to probe inside a sample.
- In complex samples, encountered across a range of applications, signals coming from layers (levels) located at different depths in a sample tend to be highly independent in a statistical sense, given that different layers are likely to contain different structures and a wide range of local density and topology variations.

These realizations ultimately allowed the inventors to develop a generalized, automated method of tomographic (volume) imaging of a general class of samples using SEM. More particularly, exploiting the insights set forth above, the inventors found that they could use second-order and higher-order statistics from a range of Blind Source Separation (BSS) techniques to disentangle (de-convolute / spatially resolve) signals coming from different layer (level) depths within a general sample. In particular, the technique of Principal Component Analysis (PCA) was found to be quite successful in this context.

In a particular embodiment of the method according to the present invention, PCA is applied to a set of N spatially aligned (and, if necessary, scaled) images acquired with varying primary beam energy and BS electron detection, or alternatively using energy band filtering. After mean-centering each image and applying PCA, one obtains a set of N de-correlated images that are related to the input ones by linear transformations (each input image can be expressed as a linear combination of these de-correlated images). The linear mappings can be obtained using various suitable methods, such as a Karhunen-Loeve Transform, for example. The inventors noticed that new information in BS images acquired with increasing primary landing energy is mostly due to signals coming from new depth layers reached by the incident electrons; the effect of PCA de-correlation thus results in the effective separation of the different depth layers. Using PCA, one obtains several de-correlated images, including a strong component associated with the matrix material of the sample (e.g. epoxy in the case of stained life-science samples). The inventors observed that sets of images with lower Eigenvalues in a Karhunen-Loeve transform correspond to deeper layers. In the image associated with these deeper components, top layers are canceled using information from all available lower energy images.

Based on these observations, one can develop an algorithm that uses N input images, as follows:

Step1. Acquire N BS images at increasing landing energies.
Step2. Laterally align and/or scale the image sequence thus obtained.
Step3. To compute (distil) the image associated with a discrete layer (level) of ordinal k counted from the sample surface (k = 1...N):

- Apply PCA decomposition to the first k images in the sequence.
- Boost independent components having low weight (which emanate from deeper layers); this can, for example, be done by multiplying such components by a weighting factor that is equal or proportional to the reciprocal of their PCA (e.g. Karhunen-Loeve) Eigenvalue.
- Reconstruct a depth image with re-weighted independent components and a background (matrix) component.

Step 4. Post-process the obtained sequence using 2D and 3D de-noising and restoration methods.

Using such an approach, the relative thickness of the computed slices (layers/levels) can be adjusted by suitable choice of the beam energy increments applied during acquisition of the BS image sequence. This can result in very high depth resolution in many applications, especially when the associated PSF has good linearity.

The discussion above makes multiple references to PCA, but it should be realized that this is not the only BSS technique that can be applied in the context of the present invention. For example, one could alternatively employ Independent Component Analysis (ICA), which decomposes a set of input images in a way similar to PCA, but minimizes an entropy-based mutual information criterion instead of a correlation criterion. Alternatively, one could consider employing techniques such as Singular Value Decomposition (SVD) or Positive Matrix Factorization (PMF). More information with regard to BSS techniques can, for example, be gleaned from:

{1} P. Comon and C. Jutten, Handbook of Blind Source Separation: Independent Component Analysis and Applications, Academic Press, 2010.
{2} A. Hyvärinen and E. Oja, Independent Component Analysis: Algorithms and Applications, Neural Networks, 13 (4-5):411-430, 2000.
{3} I.T. Jolliffe, Principal Component Analysis, Series: Springer Series in Statistics XXIX, 2nd ed., Springer, NY, 2002.

In the dissertation above:

(i) The stimulated radiation comprises backscattered (BS) electrons. However, in principle, one could also exploit other types of stimulated radiation, such as secondary electrons or X-ray radiation, for example. An advantage of BS electrons over X-rays, for example, is that X-rays are generally not produced at relatively low incident beam energies, whereas BS electrons are.
(ii) The beam parameter (P) is beam energy (landing energy). However, in principle, one could alternatively select beam convergence angle (incidence angle) or beam focal depth (penetration depth) as the beam parameter to be varied.
(iii) The measurand (M) is detector current (associated with BS electrons). However, one could also select intensity as a measurand (e.g. when detecting X-rays as stimulated radiation).

(iv) The imaging quantity (Q) is intensity. However, one could also choose other imaging quantities, such as current, energy spread or angular distribution, for example. Often, Q and M will be chosen to be the same quantity; however, one can also choose a different quantity for Q than for M.

In an embodiment of the method according to the present invention, successive values of the measurement parameter (P) associated with successive measurement sessions differ from one another by a substantially constant increment ($\Delta P$), and successive discrete depth levels in the obtained result set (R) are correspondingly separated from one another by a substantially constant distance increment ($\Delta L$). In experiments, the inventors observed that, for example, in commonly used, high-Z-stained biological samples, increments in landing energy of 100eV typically resulted in distance increments of the order of about 4-5 nm (i.e. of the order of a bilayer) between successive subsurface levels ($L_k$) in the result set R. However, it should be noted that P does not have to change by a constant increment between successive measurement sessions, and that successive levels $L_k$ also do not have to be spaced at equal distance increments.

One should take care not to confuse the present invention with known tomographic techniques based on Transmission Electron Microscopy (TEM), whereby depth information is gleaned from a sample by employing a range of different sample tilt angles. *Inter alia,* one can identify the following differences between the two:

- TEM apparatus is generally much more expensive than SEM apparatus.
- The TEM approach uses much higher input beam energies (typically of the order of 200-300 keV), which can cause sample damage. In contrast, the method according to the present invention works satisfactorily with much lower input beam energies (e.g. of the order of 1-5 keV).
- TEM tomography can only be used on very thin samples (generally < 1 $\mu$m in thickness). Because the present invention does not rely on transmission of electrons through the sample, it does not suffer from this restriction on sample thickness.
- A SEM-based technique such as that used in the present invention has a much greater lateral reach than a TEM-based technique, because of the (lateral) scanning nature of the former.
- By its very nature, TEM tomography does not generate the type of convoluted depth data associated with the present invention, and, accordingly, does not require statistical processing techniques to perform depth resolution upon such convoluted data.

The invention will now be elucidated in more detail on the basis of exemplary embodiments and the accompanying schematic drawings, in which:

Figure 1 shows a flowchart that schematically depicts a scheme for performing a particular embodiment of the method according to the present invention.

Figures 2A and 2B show results of a SEM-based investigation of a stained biological sample, without (Fig. 2A) and with (Fig. 2B) application of a method according to the present invention.

In the Figures, where pertinent, corresponding parts are indicated using corresponding reference symbols.

Embodiment 1

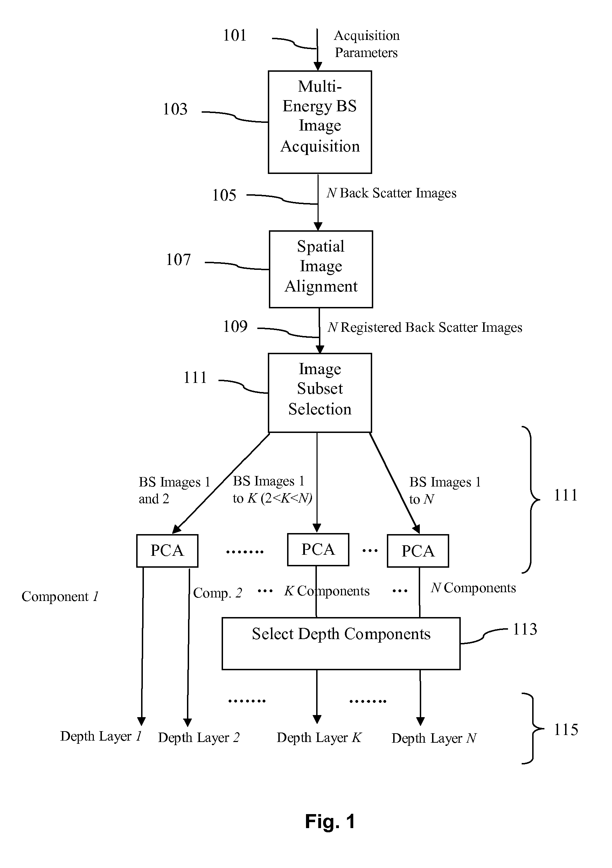

Figure 1 shows a flowchart of an embodiment of a SEM-based 3D volume imaging method according to the present invention. The various steps in this flowchart can be further elucidated as follows:

101: Acquisition parameters are decided upon. Here, one makes selections as regards N (number of measurement sessions), P (beam parameter to be varied between measurement sessions), $\Delta P$ (size of increment in P between measurement sessions), the stimulated radiation to be detected, and M (which measurand of the stimulated radiation is to be measured). For example, one may choose N = 7, P = landing energy, $\Delta P$ = 100 eV, stimulated radiation = BS electrons, M = BS electron current.

103: On the basis of the parameters selected in step 101, a set of BS images is acquired. These images represent convoluted data as regards depth information in the sample under investigation.

105: The N acquired BS images form a raw data set.

107: The elements of the data set are laterally aligned and/or scaled with one another to form an aligned data set.

109: The aligned data set acts as input set for a statistical de-convolution operation in accordance with the invention.

111: An iterative series of data processing steps is performed in which, for each integral value of k in the range [2,..., N], PCA decomposition is applied to the subset of data pairs ($P_i$, $M_i$), i = 1,...,k.

113: Independent components of this decomposition having least correlation to the decomposed subset are identified.

115: The least-correlated components thus identified are associated with level $L_k$ beneath the surface S.

In this manner, one generates a result set $R = ((Q_1, L_i),...,(Q_N, L_N))$ comprising a spectrum of discrete levels $L_k$ progressing from the surface (S) into the sample.

Embodiment 2

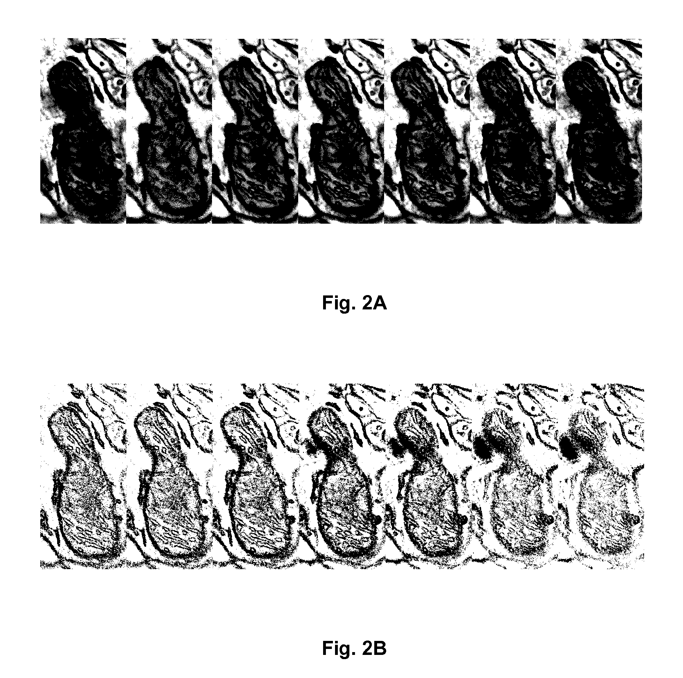

Figures 2A and 2B show results of SEM-based 3D slicing into progressively deeper layers of a stained biological sample (in this particular case, a brain cell of a mouse). In both cases, the sample was irradiated at progressively higher energies - in the range 700eV to 1900eV, in 200eV increments - and BS electrons emanating from the irradiated sample were detected. The results are illustrated as follows:

- Figure 2A shows the BS image sequence of a mitochondrion in the sample, without any attempt at de-convolution of detected data.
- Figure 2B shows a corresponding image sequence after application of a method according to the present invention, representing de-convolved, depth-resolved images of the same mitochondrion, and revealing 3D structures not (clearly) visible in Figure 2A.

Embodiment 3

The linearity assumptions in image formation elucidated above can be represented in the model:

$$Q = AI \tag{1}$$

in which:

$I = (I_1, I_2 ... I_N)T$ is the set of images acquired by varying beam parameters;
$Q = (Q_1, Q_2,..., Q_N)^T$ is a set of source images that are statistically de-correlated and that represent information coming from different depth layers (levels);
$A = (a_1, a_2,..., a_N)^T$ is a square matrix transforming the original images into so-called principal components.
PCA decomposition obtains the factorization in equation (1) by finding a set of orthogonal components, starting with a search for the one with the highest variance.

The first step consists in minimizing the criterion:

$$a_1 = \arg\max_{\|a\|=1} E\left\{(a^T I)^2\right\} \tag{2}$$

The next step is to subtract the found component from the original images, and to find the next layer with highest variance.

At iteration $1 < k \le N$, we find the *kth* row of the matrix A by solving:

$$a_k = \arg\max_{\|a\|=1} E\left\{(a^T (I - \sum_{i=1}^{k-1} w_i w_i^T I))^2\right\} \tag{3}$$

It can be shown (see, for example, literature references {1} and {3} referred to above) that successive layer separation can be achieved by using so-called Eigenvector Decomposition (EVD) of the covariance matrix $\Sigma_I$ of the acquired images:

$$\Sigma_I = E\left\{I^T I\right\} = EDE^T \tag{4}$$

in which:

E is the orthogonal matrix of eigenvectors of $\Sigma_I$;
$D = diag(d_1,...,d_N)$ is the diagonal matrix of Eigenvalues.

The principal components can then be obtained as

$$Q = E^T I \tag{5}$$

The Eigenvalues are directly related to the variance of the different components:

$$d_i = (\mathrm{var}(Q_i))^2 \tag{6}$$

In cases in which noise plays a significant role, the components with lower weights (Eigenvalues) may be dominated by noise. In such a situation, the inventive method can be limited to the K $(K<N)$ most significant components. The choice to reduce the dimensionality of the image data can be based on the cumulative energy and its ratio to the total energy:

$$r = \frac{\sum\limits_{i=1}^{K} d_i}{\sum\limits_{i=1}^{N} d_i} \tag{7}$$

One can choose a limit for the number of employed layers $K$ based on a suitable threshold value t. A common approach in PCA dimensionality reduction is to select the lowest $K$ for which one obtains $r \geq t$. A typical value for $t$ is 0.9 (selecting components that represent 90% of the total energy).

Noise effects can be minimized by recombining several depth layers with a suitable weighting scheme. Additionally, re-weighting and recombination of layers can be useful to obtain an image contrast similar to the original images. In the previously described PCA decomposition, the strongest component (in terms of variance) is commonly associated with the background (matrix) material. Adding this component to depth layers enhances the visual appearance and information content of the obtained image. One can achieve the effect of boosting deeper-lying layers, reducing noise, and rendering proper contrast by re-scaling the independent components by their variances and reconstructing the highest-energy image using the rescaled components, as follows:

$$Q = ED^{-\frac{1}{2}} E^T I \tag{8}$$

The skilled artisan will appreciate that other choices for the linear weighting of depth layers can also be used.

Embodiment 4

As an alternative to the PCA decomposition set forth above, one can also employ a BSS approach based on ICA. In ICA, one assumes a linear model similar to (1). The main difference with PCA is that one minimizes a higher-order statistical independence criterion (higher than the second-order statistics in PCA), such as so-called Mutual Information (MI):

$$MI(Q_1,...,Q_N) = \sum_{i=1}^{N} H(Q_i) - H(Q) \qquad (9)$$

With marginal entropies computed as:

$$H(Q) = -\sum_{k=1}^{S} P(Q_i = q_k) \log(P(Q_i = q_k)) \qquad (10)$$

and the joint entropy:

$$H(Q) = -\sum_{k=1}^{S} P(Q_i = q_k,...,Q_N = q_k) \log(P(Q_i = q_k,...,Q_N = q_k)) \qquad (11)$$

in which:

$P(Q)$ *is* the probability distribution of the imaging quantity $Q$;
$q_k$ *is* a possible value for said imaging quantity; and
S is the total number of scanned sites on the sample (e.g. in the case of rectangular images, this is the product of height and width).

Other criteria - such as the so-called Infomax and Negentropy - can also be optimized in ICA decomposition. Iterative methods - such as FastICA - can be employed to efficiently perform the associated depth layer separation task. Adding more constraints to the factorization task can lead to more accurate reconstruction. If one adds the condition that sources (layers) render positive signals and that the mixing matrix is also positive, one moves closer to the real physical processes underlying image formation. A layer separation method based on such assumptions may use the so-called Non-Negative Matrix Decomposition (NMD) technique with iterative algorithms.
For more information, see literature references {1} and {2} cited above. We claim as follows:

**Claims**

1. A method of investigating a sample using Scanning Electron Microscopy, comprising the following steps:

- Irradiating a surface (S) of the sample using a probing electron beam in a plurality (N) of measurement sessions, each measurement session having an associated beam parameter (P) value that is chosen from a range of such values and that differs between measurement sessions;
- Detecting stimulated radiation emitted by the sample during each measurement session, associating a measurand (M) therewith and noting the value of this measurand for each measurement session, thus allowing compilation of a data set (D) of data pairs $(P_i, M_i)$, where $1 \le i \le N$,

**characterized in that**:

- A statistical Blind Source Separation technique is employed to automatically process the data set (D) and spatially resolve it into a result set (R) of imaging pairs $(Q_k, L_k)$, in which an imaging quantity (Q) having value $Q_k$ is associated with a discrete depth level $L_k$ referenced to the surface S.

2. A method according to claim 1, wherein:

- Successive values of the measurement parameter (P) associated with successive measurement sessions differ from one another by a substantially constant increment ($\Delta P$);
- Correspondingly, successive discrete depth levels in the obtained result set (R) are separated from one another by a substantially constant distance increment ($\Delta L$).

3. A method as claimed in claim 1 or 2, wherein:

- The beam parameter (P) is selected from the group comprising beam energy, beam convergence angle and beam focal depth;
- The stimulated radiation is selected from the group comprising secondary electrons, backscattered electrons and X-ray radiation;
- The measurand (M) is selected from the group comprising intensity and current.

4. A method as claimed in any of claims 1-3, wherein the imaging quantity (Q) is selected from the group comprising intensity, current, angular distribution and energy spread.

5. A method according to any of the preceding claims, wherein the statistical Blind Source Separation technique is selected from the group comprising Principal Component Analysis (PCA) and Independent Component Analysis (ICA).

6. A method according to claim 5, wherein:

- The statistical Blind Source Separation technique is PCA;
- The beam parameter (P) comprises beam energy, whereby successive measurement sessions have a larger associated value of this parameter;
- The stimulated radiation comprises secondary electrons and the measurand (M) comprises current;
- The imaging quantity (Q) comprises intensity;
- An alignment transform is performed on the elements of the data set D so as to laterally align and/or scale them;
- An iterative series of data processing steps is performed in which, for each integral value of k in the range [2,..., N]:

  - PCA decomposition is applied to the subset of data pairs ($P_i$, $M_i$), i = 1,...,k;
  - An independent component of this decomposition having least correlation to said subset is identified, and is associated with level $L_k$ beneath the surface S, whereby the result set R = (($Q_1$, $L_1$),...,($Q_N$, $L_N$)) is generated for a spectrum of discrete levels $L_k$ progressing from the surface (S) into the sample.

7. A method according to claim 6, wherein:

- Components of the PCA decomposition are relatively weighted using a weight factor that, for a given component, is equal or proportional to the reciprocal of the Eigenvalue for that component;
- The result set (R) is augmented by adding to its elements a factor corresponding to a matrix response of the sample.

8. A method according to claim 6 or 7, wherein said PCA decomposition is a Karhunen-Loeve transform operation.

9. A method according to any of the preceding claims, wherein the obtained result set (R) is post-processed using statistical noise reduction and restoration techniques.

10. A method according to any of the preceding claims, wherein the result set (R) yields information regarding both the geometry and the material composition of the sample.

101 — | Acquisition Parameters

103 — **Multi-Energy BS Image Acquisition**

105 — *N* Back Scatter Images

107 — **Spatial Image Alignment**

109 — *N* Registered Back Scatter Images

111 — **Image Subset Selection**

BS Images 1 and 2 / BS Images 1 to *K* (2<*K*<*N*) / BS Images 1 to *N*

} 111

PCA  ······· PCA ··· PCA

Component *1* / Comp. *2* ··· *K* Components ··· *N* Components

**Select Depth Components** — 113

······· ·······

Depth Layer *1*  Depth Layer *2*  Depth Layer *K*  Depth Layer *N*  } 115

**Fig. 1**

**Fig. 2A**

**Fig. 2B**

Europäisches
Patentamt

European
Patent Office

Office européen
des brevets

## EUROPEAN SEARCH REPORT

Application Number

EP 10 18 8162

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HARAUZ ET AL: "Symmetry in the 2.25 MDa homomultimeric phosphoenolpyruvate synthase fromStaphylothermus marinus: Analyses of negatively stained preparations", MICRON, PERGAMON, OXFORD, GB, vol. 29, no. 2-3, 1 April 1998 (1998-04-01), pages 161-173, XP005624841, ISSN: 0968-4328, DOI: DOI:10.1016/S0968-4328(97)00069-3 * page 162, left-hand column, last line - page 163 * * figure 7 *  ----- | 1 | INV. H01J37/22 H01J37/28 |
| A | US 2008/116376 A1 (TAKANE ATSUSHI [JP] ET AL) 22 May 2008 (2008-05-22)  ----- | 1 | |
|  |  |  | TECHNICAL FIELDS SEARCHED (IPC)  H01J |

The present search report has been drawn up for all claims

| Place of search | Date of completion of the search | Examiner |
|---|---|---|
| Munich | 25 March 2011 | Krauss, Jan |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

........................................................................................

& : member of the same patent family, corresponding
   document

EPO FORM 1503 03.82 (P04C01)

**ANNEX TO THE EUROPEAN SEARCH REPORT
ON EUROPEAN PATENT APPLICATION NO.**

EP 10 18 8162

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2011

| Patent document cited in search report | Publication date | Patent family member(s) | Publication date |
|---|---|---|---|
| US 2008116376 A1 | 22-05-2008 | NONE | |

EPO FORM P0459

For more details about this annex : see Official Journal of the European Patent Office, No. 12/82

## REFERENCES CITED IN THE DESCRIPTION

**Patent documents cited in the description**

- US 5412210 A

**Non-patent literature cited in the description**

- **P. COMON ; C. JUTTEN.** Handbook of Blind Source Separation: Independent Component Analysis and Applications. Academic Press, 2010
- **A. HYVÄRINEN ; E. OJA.** Independent Component Analysis: Algorithms and Applications. *Neural Networks,* 2000, vol. 13 (4-5), 411-430
- Series: Springer Series in Statistics XXIX. **I.T. JOLLIFFE.** Principal Component Analysis. Springer, 2002